(19) Europäisches Patentamt

European Patent Office

Office européen des brevets

(11) **EP 1 037 383 A2**

(12) **EUROPÄISCHE PATENTANMELDUNG**

(43) Veröffentlichungstag:
20.09.2000 Patentblatt 2000/38

(51) Int. Cl.[7]: **H03H 9/17**, H03H 9/05

(21) Anmeldenummer: 00101372.1

(22) Anmeldetag: 24.01.2000

(84) Benannte Vertragsstaaten:
**DE FR IT**
Benannte Erstreckungsstaaten:
**AL LT LV MK RO SI**

(30) Priorität: **18.03.1999 JP 7380299**

(71) Anmelder:
**Murata Manufacturing Co., Ltd.
Nagaokakyo-shi Kyoto-fu 617-8555 (JP)**

(72) Erfinder:
• **Kuroda, Hideaki,
c/o Intell. Prop. Dept.
Nagaokakyo-shi, Kyoto-fu 617/8555 (JP)**
• **Yoshida, Ryuhei,
c/o Intell. Prop. Dept.
Nagaokakyo-shi, Kyoto-fu 617/8555 (JP)**

(74) Vertreter:
**Zinnecker, Armin, Dipl.-Ing. et al
Lorenz-Seidler-Gossel,
Widenmayerstrasse 23
80538 München (DE)**

(54) **Piezoelektrische Vibratoranordnung und piezoelektrische Resonanzvorrichtung**

(57) There is provided a piezoelectric vibration device comprising: a piezoelectric element having a longitudinal direction, a pair of ends opposed to each other along the longitudinal direction, top and bottom surfaces provided between the pair of ends and opposed to each other, and beveled surfaces disposed in the vicinity of the pair of ends such that the thickness of the piezoelectric element gradually decreases toward the pair of ends; first and second vibration electrodes disposed on the top surface and the bottom surface of said piezoelectric element substantially at the center in the longitudinal direction of said piezoelectric element so as to oppose each other via the piezoelectric element, opposing portions of the first and the second vibration electrodes constituting a vibrator; and the surface roughness of said beveled surfaces being greater than the surface roughness of the surfaces of the piezoelectric element beneath the vibration electrodes at the opposing portions of said first and second vibration electrodes.

Fig. 1

EP 1 037 383 A2

Printed by Xerox (UK) Business Services
2.16.7 (HRS)/3.6

**Description**

BACKGROUND OF THE INVENTION

1. Industrial Field of the Invention

The present invention relates to piezoelectric vibration devices and to piezoelectric resonance components for use in piezoelectric resonators, piezoelectric filters, or the like, and particularly relates to a piezoelectric vibration device and a piezoelectric resonance component each having a beveled surface formed near each end of a piezoelectric element by beveling.

2. Description of the Related Art

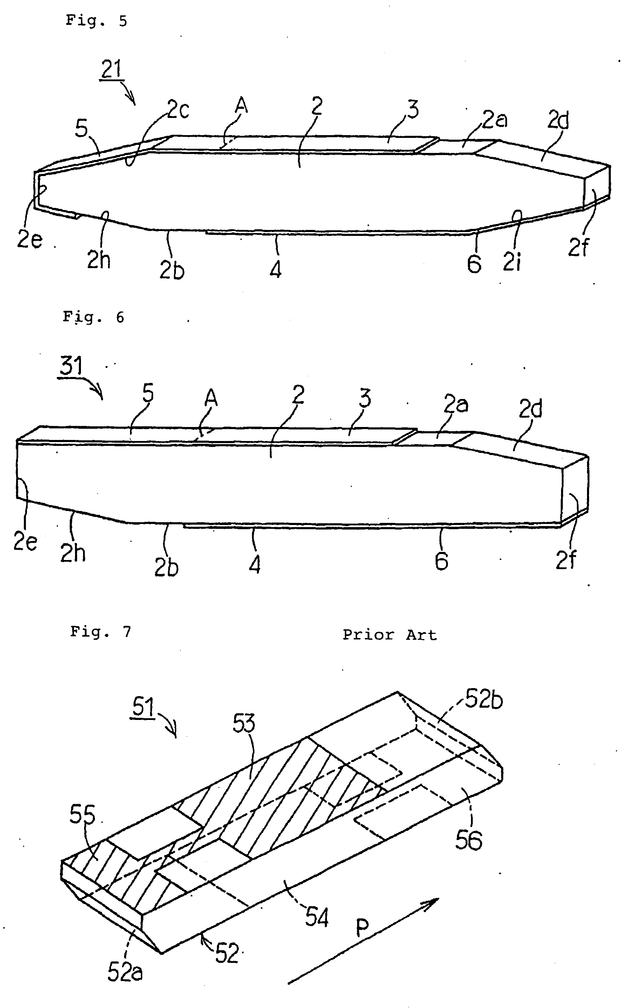

Energy-trapping piezoelectric devices have been broadly used in resonators, band-pass filters, or the like. An example of a piezoelectric device of this sort is disclosed in Japanese Unexamined Patent Publication No. 56-165413. Fig. 7 shows a perspective view of a piezoelectric device described in the related art. A piezoelectric device 51 is configured employing a piezoelectric substrate 52. The piezoelectric substrate 52 is polarized along a direction marked by an arrow P in Fig. 7, namely in a direction parallel to the main surface. In the centers of the top surface and the bottom surface of the piezoelectric substrate 52, vibration electrodes 53 and 54 are formed so as to oppose each other via the piezoelectric substrate 52. The vibration electrode 53 is electrically connected with a terminal electrode 55 formed at one end of the piezoelectric substrate 52. On the bottom surface of the piezoelectric substrate 52, the vibrating electrode 54 is connected with a terminal electrode 56 formed on the other end of the piezoelectric substrate 52. In the piezoelectric device 51, at least one of four ridges at longitudinal ends of the piezoelectric substrate 52 is cut along a width direction of the piezoelectric substrate 52. In other words, beveled surfaces 52a and 52b are formed by beveling.

In piezoelectric device 51, by properly setting dimensions of the beveled surfaces 52a and 52b, spurious responses due to a longitudinal mode may be suppressed. Similarly, also in Japanese Unexamined Utility Model Publication No. 1-40920, a construction is disclosed in which, in a piezoelectric resonator employing thickness shear vibration, both ends of a piezoelectric substrate are beveled. Here, by forming a beveled surface by beveling, energy trap efficiency is increased and filtering characteristics are improved. The publication also describes that spurious responses due to a contour mode may be suppressed, and it is easier to make the device compact.

As described in the above-mentioned related art, in an energy-trapping piezoelectric device employing thickness shear vibration, it is known that by forming a beveled surface on a piezoelectric substrate, spurious responses due to a longitudinal mode or a contour mode may be suppressed, and energy trap efficiency may be increased.

In a conventional energy-trapping piezoelectric device having a beveled surface formed thereon, however, there is a problem in that by increasing energy trap efficiency, a response of a higher-order mode vibration which results in spurious responses becomes larger.

When a thickness shear mode energy-trapping piezoelectric device is utilized as an oscillator, suppression of harmonics generated at frequencies of odd-number multiples of a fundamental vibration is indispensable. When suppression of the harmonics is insufficient, oscillations are likely to be made at frequencies of odd-number multiples, such as three times, five times, or the like, of a transmission frequency.

SUMMARY OF THE INVENTION

To overcome the above described problems, preferred embodiments of the present invention provide, in an energy-trapping piezoelectric vibration device employing a thickness shear mode, a piezoelectric vibration device and a piezoelectric resonance component which are capable of not only suppressing spurious responses due to a longitudinal direction mode and a contour mode, but also of effectively suppressing spurious responses due to higher-order modes, thus enabling improved resonance characteristics and filtering characteristics to be obtained.

One preferred embodiment of the present invention provides a piezoelectric vibration device comprising: a piezoelectric element having a longitudinal direction, a pair of ends opposed to each other along the longitudinal direction, top and bottom surfaces provided between the pair of ends and opposed to each other, and beveled surfaces disposed in the vicinity of the pair of ends such that the thickness of the piezoelectric element gradually decreases toward the pair of ends; first and second vibration electrodes disposed on the top surface and the bottom surface of said piezoelectric element substantially at the center in the longitudinal direction of said piezoelectric element so as to oppose each other via the piezoelectric element, opposing portions of the first and the second vibration electrodes constituting a vibrator; and the surface roughness of said beveled surfaces being greater than the surface roughness of the surfaces of the piezoelectric element beneath the vibration electrodes at the opposing portions of said first and second vibration electrodes.

Preferably, $Ra_1 - Ra_2 > 0.3\,\mu m$ is satisfied where $Ra_1$ is the center line mean roughness according to Japanese Industrial Standard B0601 of said beveled surface, and $Ra_2$ is the center line mean roughness of the surface of the piezoelectric element beneath said first and said second vibration electrodes.

In the above described piezoelectric vibration device, a pair of the beveled surfaces may be provided on the top surface of said piezoelectric element in the vicinity of the ends thereof, and no beveled surface may be provided on the bottom surface thereof.

In the above described piezoelectric vibration device, a pair of the beveled surfaces are provided in the vicinity of the ends of the piezoelectric element on each of the top surface and the bottom surface of said piezoelectric element.

Preferably, the piezoelectric element comprises piezoelectric ceramics.

Another preferred embodiment of the present invention provides a piezoelectric resonance component, comprising: a case substrate; the piezoelectric vibration device described above which is mounted on said case substrate; and a casing member mounted on said case substrate so as to surround said piezoelectric vibration device.

Preferably, the above described piezoelectric resonance component further comprises a capacitor device mounted on the case substrate; wherein said piezoelectric vibration device is secured on said capacitor device and mounted on said case substrate via said capacitor device, and a built-in load capacitance type oscillator is configured by said piezoelectric vibration device and said capacitor device.

In the piezoelectric vibration device according to the present invention, since a beveled surface is provided on a piezoelectric element which comprises an energy-trapping piezoelectric vibrator, spurious responses due to a longitudinal mode or a contour mode can be suppressed, and further, since the surface roughness of the beveled surface is greater than the surface roughness of the surfaces of the piezoelectric element beneath the vibration electrode at the opposing portions of the vibration electrodes, spurious responses due to higher-order modes can be effectively suppressed.

Consequently, a piezoelectric vibration device which has superior energy trap, is less influenced by unwanted spurious responses, and which has superior resonance characteristics and filtering characteristics can be provided.

In the present invention, when the center line mean roughness $Ra_1$ of beveled surfaces and the center line mean roughness $Ra_2$ of the surfaces of a piezoelectric element beneath vibration electrodes have a relationship expressed by $Ra_1 - Ra_2 > 0.3\ \mu m$, spurious responses due to higher-order modes can be more effectively suppressed.

Further, in a configuration having a pair of beveled surfaces provided in the vicinity of the ends on the top surface of a piezoelectric element and having no beveled surface proivded on the bottom surface of the piezoelectric element, the piezoelectric element can be mounted from the bottom surface on a case substrate, a printed circuit board, or the like in a stabilized way.

On the other hand, when a pair of beveled surfaces are provided in the vicinity of ends on each of the top surface and the bottom surface of a piezoelectric element, the piezoelectric element can be mounted with ease on a case substrate or the like by an automatic machine without doing the complicated task of selecting the directional property, since the configurations on the top surface and the bottom surface of the piezoelectric element are symmetrical.

Although, in a piezoelectric vibration device according to the present invention, a piezoelectric ceramic or a piezoelectric single crystal may be used as a piezoelectric element, when various kinds of piezoelectric ceramics are used, a variety of resonance characteristics and filtering characteristics can be realized with ease by controlling the composition of the piezoelectric ceramics.

In a piezoelectric resonance component according to the present invention, since a piezoelectric vibration device according to the present invention is mounted on a case substrate, and a casing member is fixed to the case substrate so as to surround the piezoelectric vibration device, a piezoelectric resonance component having improved resonance characteristics and filtering characteristics, in which unwanted spurious responses are suppressed, and which is capable of being easily mounted on a printed circuit board or the like, can be provided.

Further, in a piezoelectric resonance component according to the present invention, when a capacitor device mounted on a case substrate is further provided, a piezoelectric vibration device is secured on the capacitor device, and a built-in load capacitance type piezoelectric oscillator is comprised of a piezoelectric vibration device and a capacitor device, the built-in load capacitance type piezoelectric oscillator can be configured by a single piezoelectric resonance component, and a piezoelectric vibration device according to the present invention is used therein, thus a piezoelectric resonance component which positively oscillates at a desired frequency and is free from abnormal oscillations or the like, can be provided.

Other features and advantages of the present invention will become apparent from the following description of the invention which refers to the accompanying drawings.

BRIEF DESCRIPTION OF DRAWINGS

Fig. 1 shows a perspective view of a piezoelectric vibration device according to a first embodiment of the present invention.

Fig. 2 is a chart showing a relationship between $Ra_1 - Ra_2$, namely between the surface roughness $Ra_1$ of beveled surfaces and the surface roughness

Ra$_2$ of the surfaces of a piezoelectric substrate beneath vibration electrodes, and a response of spurious responses due to a third harmonic wave in a piezoelectric vibration device of a first embodiment.

Fig. 3 shows an exploded perspective view of a piezoelectric resonance component according to an embodiment of the present invention.

Fig. 4 shows a partially cutaway perspective view for describing a piezoelectric resonance component according to an embodiment of the present invention.

Fig. 5 shows a perspective view of a piezoelectric vibration device according to a second embodiment of the present invention.

Fig. 6 shows a perspective view of a piezoelectric vibration device according to a third embodiment of the present invention.

Fig. 7 shows a perspective view of an example of a prior art piezoelectric vibration device.

DESCRIPTION OF PREFERRED EMBODIMENTS

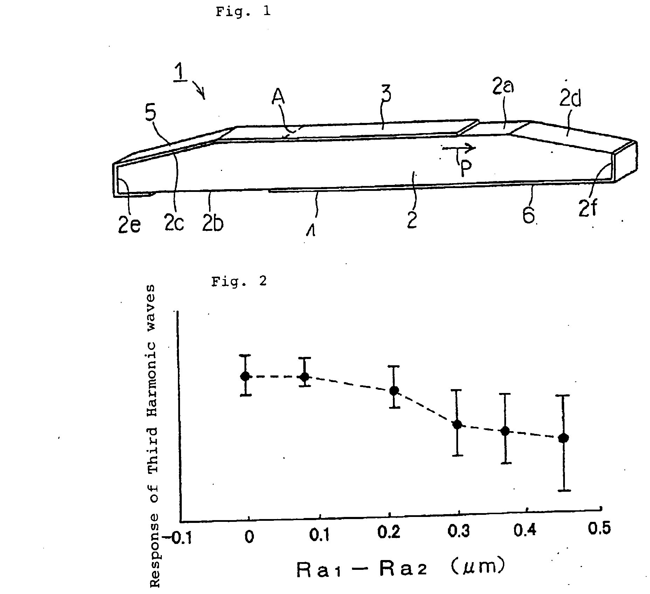

Fig. 1 shows a perspective view of a piezoelectric vibration device according to a first embodiment of the present invention.

A piezoelectric vibration device 1 is an energy-trapping piezoelectric resonator adapted to be vibrated in a thickness shear vibration mode.

The piezoelectric vibration device 1 is constructed by employing an elongated piezoelectric substrate 2. The piezoelectric substrate 2 in this embodiment comprises PZT based piezoelectric ceramics, and is polarized in a direction marked by an arrow P, as illustrated in Fig. 1. In other words, the piezoelectric substrate 2 is polarized in a direction parallel to a top surface 2a and a bottom surface 2b of the piezoelectric substrate 2 along the longitudinal direction of the piezoelectric substrate 2.

The piezoelectric substrate 2 may be comprised of piezoelectric ceramics other than PZT-based piezoelectric ceramics, and alternatively may be comprised of a piezoelectric single crystal such as quartz or the like. Further, instead of the piezoelectric substrate 2, a rod-shaped, not board-like, piezoelectric device may be employed.

On the top surface 2a of the piezoelectric substrate 2, beveled surfaces 2c and 2d are formed by beveling in the vicinity of the ends of the piezoelectric substrate 2. Namely, the beveled surfaces 2c and 2d are formed by width-wise cutting of the ridges formed by the top surface 2a and the side surfaces 2e and 2f of the piezoelectric substrate 2. On the beveled surfaces 2c and 2d, the piezoelectric substrate 2 is configured such that the thickness thereof is gradually reduced toward the ends of the piezoelectric substrate 2. Namely, the beveled surfaces 2c and 2d are planar slopes which approach the bottom surface 2b toward the ends of the piezoelectric substrate 2. However, the beveled surfaces 2c and 2d may be curved surfaces. On the other hand, in the center of the top surface 2a of the piezoelectric substrate 2, a first vibration electrode 3 is provided, and in the center of the bottom surface 2b of the piezoelectric substrate 2, a second vibration electrode 4 is provided. The first and the second vibration electrodes 3 and 4 are provided at the center in the longitudinal direction of the piezoelectric substrate 2 so as to oppose each other via the piezoelectric substrate 2. The portion where the vibration electrodes 3 and 4 are vertically opposed constitutes a piezoelectric vibrator.

Meanwhile, the vibration electrode 3 is linked with an extended electrode 5, which is extended so as to reach the bottom surface 2b of the piezoelectric vibrator via the beveled surface 2c and the side surface 2e. However, the vibration electrode 3 and the extended electrode 5 are simultaneously formed of the same material. In other words, the extended electrode 5 is linked with the vibration electrode 3. Accordingly, in order to clarify a boundary between the vibration electrode 3 and the extended electrode 5, the boundary is shown by a dotted line A in Fig. 1.

On the other hand, an extended electrode 6 is linked to the vibration electrode 4 provided on the bottom surface 2b of the piezoelectric substrate 2. The extended electrode 6 is provided so as to reach the ridge between the bottom surface 2b and the side face 2f of the piezoelectric substrate 2 from the piezoelectric vibrator.

In the piezoelectric vibration device 1 of the present embodiment, the surface roughness of the beveled surfaces 2c and 2d of the piezoelectric substrate 2 is greater than the surface roughness of the top surface 2a and the bottom surface 2b of the piezoelectric substrate 2. In other words, the surface roughness of the beveled surfaces 2c and 2d is greater than the surface roughness of the surface portions of the piezoelectric substrate 2 beneath the vibration electrodes 3 and 4.

In the piezoelectric vibration device 1 of the present embodiment, since the piezoelectric substrate 2 is polarized in a direction marked by an arrow P in Fig. 1, by applying an alternating voltage between the vibration electrodes 3 and 4, the piezoelectric vibration device 1 can be operated as a piezoelectric resonator employing a thickness shear mode. In this case, since the beveled surfaces 2c and 2d are provided in the same way as the previously described related art, spurious responses due to a longitudinal mode or a contour mode can be effectively suppressed, and energy trap can be increased.

In addition, since the surface roughness of the beveled surfaces 2c and 2d is greater than the surface roughness of the surfaces of the piezoelectric substrate beneath the vibration electrodes 3 and 4, spurious responses of higher-order modes can be effectively suppressed.

Preferably, assuming that the center line mean roughness of the beveled surfaces based according to Japanese Industrial Standard B0601 is $Ra_1$, and the center line mean roughness of the surfaces of the piezoelectric substrate beneath the vibration electrodes 3 and 4 is $Ra_2$, the expression $Ra_1 - Ra_2 > 0.3 \mu m$ is satisfied. This relation is hereinafter described with reference to Fig. 2.

As the piezoelectric vibration devices 1 of the present embodiment, piezoelectric vibration devices having various degrees of surface roughness were made, and Fig. 2 shows a chart of the results obtained from the relationship between the magnitude of the responses of third harmonic waves obtained in the piezoelectric vibration devices and the corresponding values obtained from the above described expression $Ra_1 - Ra_2$.

Meanwhile, for this experiment, as a piezoelectric vibration device 1, a piezoelectric vibration device made of PZT is used, which is 5.4 mm long, 0.5 mm wide, and 0.6 mm thick, and having a longitudinal dimension of the beveled surfaces 2c and 2d of 1.2 mm and a distance between the lower ends of the beveled surfaces 2c and 2d and the top surface of the piezoelectric substrate of 0.23 mm, and an opposing area of the vibration electrodes 3 and 4 is set at $1.25 \text{ mm}^2$.

As is clear from Fig. 2, when the value of $Ra_1 - Ra_2$ is positive, if the value of $Ra_1 - Ra_2$ increases, in other words, as the relative surface roughness of the beveled surface 2c and 2d becomes greater, the response of the third-harmonic wave becomes smaller. Specifically, if the value of $Ra_1 - Ra_2$ becomes larger than $0.3 \mu m$, it is clear that spurious responses due to the response of the third harmonic wave can be effectively suppressed.

There is no specific limitation of methods for forming beveled surfaces 2c and 2d, and for roughening the beveled surfaces 2c and 2d. In other words, a rotating grinding tool may be used for grinding a portion near both ends of the top surface 2a of the piezoelectric substrate 2, and for forming the beveled surfaces 2c and 2d of predetermined surface roughness. In addition, after forming the beveled surfaces 2c and 2d by employing a cutter or the like, a rotating grinding tool, sand blasting, or the like may be further employed for roughening the beveled surfaces 2c and 2d.

Further, although there is no specific need to grind the top surface 2a and the bottom surface 2b of the piezoelectric substrate 2, in order to realize the surface roughness relative to the beveled surfaces 2c and 2d, lapping, for example, may be employed to make the surfaces 2a and 2b more planar.

Further, it is desired that the surface roughness of the beveled surfaces 2c and 2d be larger than the surface roughness of the top surface 2a and the bottom surface 2b as previously described, and grinding marks may remain on the surface of the beveled surfaces 2c and 2d.

Although, in the present embodiment, the surface roughness of the entire top surface 2a and bottom surface 2b, and the entire beveled surfaces 2c and 2d are smaller than the surface roughness of the beveled surfaces 2c and 2d, it works well if at least the surface roughness of only the portions of the piezoelectric substrate surface beneath the vibration electrodes 3 and 4 is smaller than the surface roughness of the beveled surfaces 2c and 2d.

In the piezoelectric vibration device according to the first embodiment, since not only spurious responses due to a contour mode or a longitudinal mode are large, but also the surface roughness of the beveled surfaces 2c and 2d is greater than the surface roughness of the top surface 2a and the bottom surface 2b of the piezoelectric substrate 2, spurious responses due to higher-order modes can be suppressed, and thereby improved resonance characteristics can be obtained.

In addition, the beveled surfaces 2c and 2d are provided in the vicinity of the ends of the top surface 2a, and no beveled surface is provided on the bottom surface 2b. In other words, when viewed from the side, the piezoelectric vibration device 1 is a trapezoid. Consequently, the piezoelectric vibration device 1 can be mounted, from the bottom surface 2b, on a printed circuit board or the like in a stabilized way for packaging.

Meanwhile, since the extended electrodes 5 and 6 are provided to reach the side surfaces 2e and 2f, respectively, when mounted on a printed circuit board, a soldering fillet can be easily formed, thus improving packaging reliability.

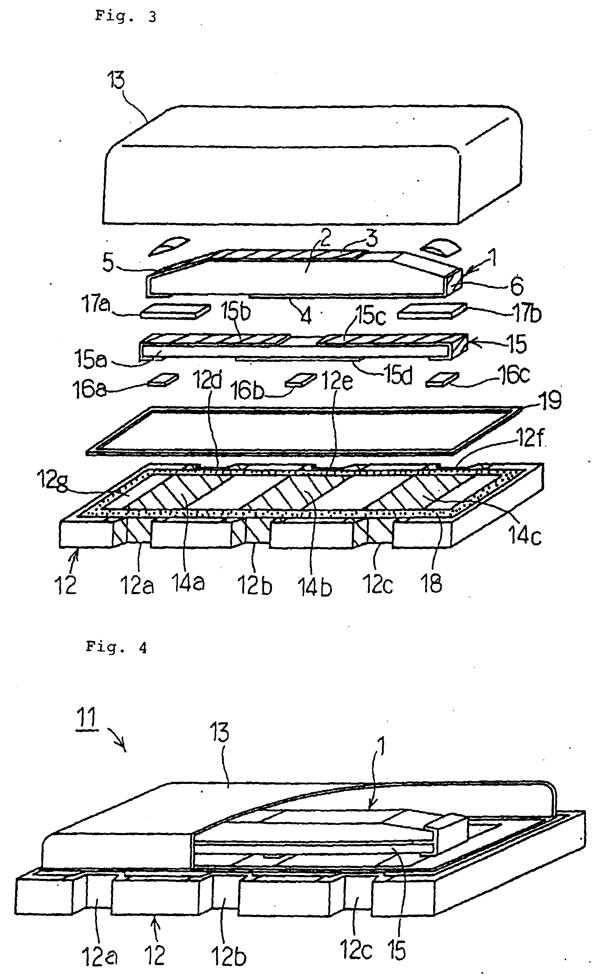

Figs. 3 and 4 respectively show an exploded perspective view and a partially cut-away perspective view of a piezoelectric resonance component employing a piezoelectric vibration device 1 according to a first embodiment.

In a piezoelectric resonance component 11, a package comprises a case substrate 12, and a metal cap 13 which is a casing member. The case substrate 12 is made of an insulating material such as alumina or the like, and has notches 12a to 12c on one of the side surfaces, and notches 12d to 12f on the other side surface. The notches 12a to 12c and the notches 12d to 12f respectively oppose each other. On the top surface of the piezoelectric substrate 12, terminal electrodes 14a to 14c are formed so as to respectively extend in the width direction of the piezoelectric substrate 12. The terminal electrodes 14a to 14c are formed to reach not only a top surface 12g, but also the inside of the above described notches 12a and 12d and 12b and 12e and 12c and 12f, respectively.

Further, on the case substrate 12, a capacitor device 15 and the piezoelectric vibration device 1 are packaged.

The capacitor device 15 is constructed by employing a dielectric substrate 15a. On the top surface of the dielectric substrate 15a, capacitor electrodes 15b and 15c are formed at the center thereof with a predetermined gap therebetween. The capacitor electrodes 15b and 15c are each formed to reach the bottom surface of the dielectric substrate 15a via the terminal surfaces at both longitudinal ends thereof. Further, the capacitor device 15 has a capacitor electrode 15d provided at the center of the bottom surface of the dielectric substrate 15a.

The portion of the capacitor electrode 15b reaching the bottom surface of the dielectric substrate 15a is electrically connected to the terminal electrode 14a by a conductive adhesive 16a. A capacitor electrode 16d is also electrically connected to the terminal electrode 14b by a conductive adhesive 16b. The portion of the capacitor electrode 15c reaching the bottom surface of a dielectric substrate is electrically connected to the terminal electrode 14c by a conductive adhesive 16c.

By doing as described above, the capacitor device 15 is electrically connected to the terminal electrodes 14a to 14c, and secured on the case substrate 12.

Further, to the top surface of the capacitor device 15, the piezoelectric vibration device 1 is bonded via conductive adhesives 17a and 17b. By the conductive adhesive 17a, the extended electrode 5 of the piezoelectric vibration device 1 is electrically connected to the capacitor electrode 14b, and the extended electrode 6 is electrically connected to the capacitor electrode 15c by the conductive adhesive 17b.

Then, the metal cap 13 is bonded to the case substrate 12 via an insulating paste 18 and an adhesive 19.

Consequently, in the piezoelectric resonance component 11 of the present embodiment, a three-terminal type built-in load capacitance type piezoelectric oscillator comprising the piezoelectric vibration device 1 and the capacitor device 15 is configured in a package comprising the case substrate 12 and the metal cap 13.

Fig. 5 shows a perspective view of a piezoelectric vibration device according to a second embodiment of the present invention.

In a piezoelectric vibration device 21, beveled surfaces 2h and 2i are also provided in the vicinity of ends thereof on the bottom surface 2b of the piezoelectric substrate 2. In other words, not only are the beveled surfaces 2c and 2d provided on the top surface 2a of the piezoelectric substrate 2, but also the beveled surfaces 2h and 2i are proivded on the bottom surface 2b thereof.

The beveled surfaces 2h and 2i are proivded symmetrically to the beveled surfaces 2c and 2d around the horizontal surface including the thickness direction center of the piezoelectric substrate 2.

Further, the extended electrode 5 is provided so as to reach the half way point of the downward beveled surface 2h from the beveled surface 2c via a side surface 2e, while the extended electrode 6 is provided to reach the beveled surface 2i from the bottom surface 2b of the piezoelectric substrate 2.

Like the piezoelectric vibration device 2 of the present embodiment, a pair of the beveled surfaces 2h and 2i may also be proivded on the bottom surface 2b of the piezoelectric substrate 2. In this case, the surface roughness of the beveled surfaces 2h and 2i is also greater than the piezoelectric substrate surface beneath the vibration electrodes 3 and 4. Consequently, in a similar way to the case of the first embodiment, spurious responses due to higher-order modes can also be effectively suppressed in the second embodiment.

In addition, in the piezoelectric vibration device 21 of the second embodiment, the shapes of the top surface and the bottom surface of the piezoelectric substrate 2 are made substantially the same, and are symmetrical. Consequently, it can be supplied to an automatic inserter without selecting the directional property, thus improving automation of mounting to a printed circuit board, a case substrate, or the like, and improving the ease of mounting.

Fig. 6 shows a perspective view of a piezoelectric vibration device according to a third embodiment of the present invention. In a piezoelectric vibration device 31, on the top surface 2a of a piezoelectric substrate 2, a beveled surface 2d is provided in the vicinity of a side surface 2f at one of the ends, while on the bottom surface 2b thereof, a beveled surface 2h is provided in the vicinity of a side surface 2e. In this case as well, by making the surface roughness of the beveled surfaces 2d and 2h greater than the surface roughness of the piezoelectric substrate surfaces beneath vibration electrodes 3 and 4, spurious responses due to higher-order modes can be effectively suppressed, in a similar way to the cases of the first and second embodiments.

In the piezoelectric vibration device 31 of the third embodiment, an extended electrode 5 is provided only on the top surface 2a of the piezoelectric substrate 2, and an extended electric 6 is also provided only on the planar bottom surface 2b of the piezoelectric substrate 2. Consequently, since an extended electrode is not required to be provided on a beveled surface, the extended electrodes 5 and 6 are provided with ease. Further, the piezoelectric vibration device 31 according to the third embodiment can be easily inserted into an automated machine without selecting the directional property, since configurations on the top surface and the bottom surface thereof are the same, thus easily enabling packaging automation.

Although the piezoelectric vibration device according to each of the first through third embodiments has first and second vibration electrodes formed on main surface of the piezoelectric substrate to constitute a piezoelectric resonator, in the present invention, a plurality of vibration electrodes may be formed on at least one of the main surfaces of the piezoelectric substrate to constitute a piezoelectric filter.

While the invention has been particularly shown and described with reference to preferred embodiments thereof, it will be understood by those skilled in the art that the forgoing and other changes in form and details may be made therein without departing from the spirit of the invention.

**Claims**

1. A piezoelectric vibration device comprising: a piezoelectric element having a longitudinal direction, a pair of ends opposed to each other along the longitudinal direction, top and bottom surfaces provided between the pair of ends and opposed to each other, and beveled surfaces disposed in the vicinity of the pair of ends such that the thickness of the piezoelectric element gradually decreases toward the pair of ends; first and second vibration electrodes disposed on the top surface and the bottom surface of said piezoelectric element substantially at the center in the longitudinal direction of said piezoelectric element so as to oppose each other via the piezoelectric element, opposing portions of the first and the second vibration electrodes constituting a vibrator; and the surface roughness of said beveled surfaces being greater than the surface roughness of the surfaces of the piezoelectric element beneath the vibration electrodes at the opposing portions of said first and second vibration electrodes.

2. The piezoelectric vibration device according to claim 1, wherein: $Ra_1 - Ra_2 > 0.3\ \mu m$ is satisfied where $Ra_1$ is the center line mean roughness according to Japanese Industrial Standard B0601 of said beveled surface, and $Ra_2$ is the center line mean roughness of the surface of the piezoelectric element beneath said first and said second vibration electrodes.

3. The piezoelectric vibration device according to claim 1 or 2, wherein a pair of the beveled surfaces are provided on the top surface of said piezoelectric element in the vicinity of the ends thereof, and no beveled surface is provided on the bottom surface thereof.

4. The piezoelectric vibration device according to claim 1 or 2, wherein a pair of the beveled surfaces are provided in the vicinity of the ends of the piezoelectric element on each of the top surface and the bottom surface of said piezoelectric element.

5. The piezoelectric vibration device according to any one of claims 1 to 4, wherein said piezoelectric element comprises piezoelectric ceramics.

6. A piezoelectric resonance component, comprising: a case substrate; the piezoelectric vibration device of any one of the claims 1 to 5 which is mounted on said case substrate; and a casing member mounted on said case substrate so as to surround said piezoelectric vibration device.

7. The piezoelectric resonance component according to claim 6, further comprising: a capacitor device mounted on the case substrate; wherein said piezoelectric vibration device is secured on said capacitor device and mounted on said case substrate via said capacitor device, and a built-in load capacitance type oscillator is configured by said piezoelectric vibration device and said capacitor device.

Fig. 1

Fig. 2

Fig. 3

Fig. 4

Fig. 5

Fig. 6

Fig. 7                                              Prior Art